# EUROPEAN PATENT APPLICATION

(11) **EP 1 308 784 A2**
(43) Date of publication of application: **07.05.2003**
(21) Application number: 02024750.8
(22) Date of filing: 06.11.2002
(51) Int. Cl.: G03F 7/20

(54) **System and method for forming features on a semiconductor substrate**

(30) Priority: 06.11.2001 US 992592
(71) Applicant: Infineon Technologies AG, 81669 München (DE)
(72) Inventor: Brown, Darius, Poughkeepsie, NY 12601 (US); Warner, Dennis, Mechanicsville, VA 2311 (US)
(74) Representative: Kindermann, Peter, Dipl.-Ing.

(57) **Abstract**

A system and method for forming features on a semiconductor wafer is provided. A reticle is part of the present system. The reticle includes a plurality of open design areas, which are used in combination with each other to form a feature on a semiconductor substrate.

## Description

### FIELD OF THE INVENTION

The present invention generally relates to mask designs for use in fabricating semiconductor devices such as integrated circuit (IC) chips. More particularly, the present invention relates to reticles and systems which use such reticles to fabricate semiconductor devices.

### BACKGROUND OF THE INVENTION

It is known to use reticles as part of a photolithographic process to form features on semiconductor substrates. Reticles may have one or more open design areas through which light waves are permitted to pass to create a corresponding feature on a substrate. In the past, such features were formed by a single exposure of a semiconductor substrate ultra violet (UV) light waves that pass through an open design area on a corresponding reticle.

If it was desired to form a new feature on a semiconductor substrate, a new reticle was used including the new desired feature design. The new reticle would then be exposed to a light source so that UV light waves could pass through the desired open design area. The semiconductor wafer would then be exposed to the light waves that pass through the open design area of the new reticle to facilitate the formation of the desired new feature.

As is known, the semiconductor substrate may comprise a silicon wafer and one or more materials such as a photoresist material that reacts to the incident UV light waves during the process of forming the desired features on the semiconductor substrate. The photoresist material can be used to facilitate feature formation through a positive or negative photolithography process.

In general, typical steps in a positive photoresist sequence may require starting with a semiconductor, made of silicon or other acceptable semiconductor material. An oxide layer may be formed on the silicon wafer. A photoresist material may then be deposited on the oxide layer so that the substrate at this point will have at least three layers including a silicon wafer, an oxide layer and a photoresist layer. UV light waves, or other acceptable light waves, may then be applied to a mask (e.g. reticle), which has at least one open design area that corresponds, either positively or negatively, to a desired feature to be formed on the semiconductor substrate. Except for the open design area, the incident light waves will be shielded by light impenetrable portions of the mask.

A developing step may then occur in which the semiconductor substrate is hard baked. This will result in a desired pattern formed in the photoresist layer, later to be formed as a feature on the semiconductor wafer. The substrate may then be subjected to an oxide etching step, where the feature is formed in the oxide. The remaining portions of the photoresist layer will protect the oxide from being etched away. various compositions may be used for the etching process, such as hydrofluoric acid or gaseous fluorine. The remaining portions of the photoresist layer can then be stripped away thereby exposing the portions of the oxide layer that were not etched in the previous step.

In a negative photoresist sequence, a semiconductor substrate including a semiconductor wafer and an oxide layer may also be used as starting material. A negative photoresist composition may then be applied to the surface of the oxide layer. A mask is then used to permit UV light waves to pass through a selected area, as in the positive photoresist sequence process. However, in the negative photoresist sequence process, the photoresist composition exposed to the incident UV light waves will become less soluble. The semiconductor substrate may then be exposed to a developing step where the photoresist material that was not exposed will be dissolved in a solvent, or otherwise removed. Thus, only the portion of the photoresist material that was exposed to the incident UV light waves will remain on the oxide layer. The substrate can then be exposed to an oxide etching process, such as a dry oxide etch, where the oxide layer that is not protected by the remaining photoresist portion is protected. All other oxide on the silicon wafer is etched away. Finally, the remaining portion of photoresist is stripped away to complete the negative feature formation sequence.

During the process of fabricating custom semiconductor devices, such as test devices and the like, it is often necessary to use a reticle having custom design features thereon. This results in substantial time delays (i.e., waiting for the reticle to be manufactured) and costs associated with obtaining the necessary new reticle having the custom design feature thereon.

The present invention overcomes the foregoing shortcomings and problems of prior art reticle systems and photolithographic methods.

### SUMMARY OF THE INVENTION

The present invention makes use of a universal reticle having multiple open design areas thereon, at least two of which are used in sequence and in combination with each other as part of a process of forming a feature on a semiconductor substrate. In accordance with one aspect of the present invention, a method of fabricating a semiconductor device is provided. The method preferably comprises arranging a reticle in a desired location. The reticle includes a plurality of open design areas. A light source is then activated to generate light waves that pass through a first open design area of the reticle. A corresponding first selected area of a semiconductor substrate is then exposed to the light waves. Light waves are then passed through a second open design area on the reticle and a corresponding second selected area on the semiconductor substrate is exposed to the light waves. Subsequently, a feature is formed on the semiconductor substrate based on a combination of at least the first and second selected areas.

The concept of forming a feature based on a combination of at least the first and selected areas is intended to encompass features that are positively or negatively formed by the combination of the first and second selected areas on the semiconductor substrate after such selected areas are exposed to light waves.

In a preferred embodiment, the light waves may comprise UV light waves. However, the process of the present invention encompasses any type of light wave sufficient to facilitate the formation of a feature on a semiconductor substrate. Other light waves that can be used include, but are not limited to, near UV light waves, x-rays and other ionizing light waves.

The present method may include using a reticle having a plurality of open design areas thereon and sequentially exposing two or more of the open design areas to light waves in conjunction with performing relative movement between the reticle and the semiconductor substrate so that a feature is formed on the substrate based on the combined open design areas of the reticle. In a preferred embodiment, the feature may be formed from a contiguous combination of two or more open design areas on the same reticle after sequential light exposures and precise relative placement between the reticle and the associated semiconductor substrate.

A feature formed in accordance with the present method may be directly formed by positive exposure of the first and second selected areas of the semiconductor substrate to the light waves. Alternatively, a feature may be indirectly formed by negative exposure of the first and second selected areas of the semiconductor substrate to light waves.

The method may comprise passing the light waves through a condenser lens prior to passing the light waves through any of the open design areas of the reticle.

It is preferable for the present method to employ a blading device having an opening and a light shielding area to shield some of the light waves so that only the unshielded light waves pass through the opening, and subsequently the first or second open design areas of the reticle. The method may further comprise the step of adjusting the opening of the blading device to a desired size so as to selectively shield the light waves from passing therethrough.

A stepper device may be used to create relative movement between the reticle and the semiconductor substrate so that the second selected area is precisely arranged with respect to the first selected area before being exposed to the light waves. The stepper device may also be used to at least partially control the positioning of the adjustable blading device.

In accordance with another aspect of the present invention, a system is provided for fabricating a semiconductor device. The system may comprise a light source and a reticle having a plurality of open design areas including first and second open design areas. The light source is adapted to generate light waves that pass through the first open design area of the reticle and contact a corresponding first selected area of a semiconductor substrate. The light waves subsequently pass through the second open design area of the reticle and contact a corresponding second selected area of the semiconductor substrate. The system also comprises a stepper device programmed to create selective relative movement between the reticle and the semiconductor substrate so that the light waves first contact the first selected area of the semiconductor substrate for a predetermined time and then contact the second selected area for a predetermined time, whereby a feature is subsequently formed on the semiconductor substrate based on a combination of at least the first and second selected areas.

The system may comprise a condenser lens, where the light waves pass through the condenser lens prior to passing through any open design areas of the reticle.

It is preferable for the system to comprise a blading device having an opening and a light shielding area to shield some of the light waves so that only the unshielded light waves pass through the opening of the first and second open design areas of the reticle. The blading device may be adjustable so that the opening thereof can be adjusted to a desired size. In one embodiment, the adjustable blading device may be at least partially controlled by the stepper device.

As used herein, the term "semiconductor substrate" shall mean a semiconductor wafer, either alone or in combination with other layers of materials used in fabricating semiconductor devices. For example, a semiconductor substrate may comprise a semiconductor wafer in combination with oxides, polysilicon, photoresist or other materials. The semiconductor substrate may include the semiconductor wafer, such as silicon or other suitable semiconductor material, by itself or in combination with other composition layers.

The foregoing features, advantages and objects of the present invention will be better understood when considered in view of the following detailed description of preferred embodiments and accompanying drawings.

### BRIEF DESCRIPTION OF THE DRAWINGS

FIG. 1 is a top plan schematic view of a reticle having multiple open design areas thereon in accordance with the present invention.

FIG. 2 is a schematic illustration of a photolithographic system including the reticle shown in FIG. 1.

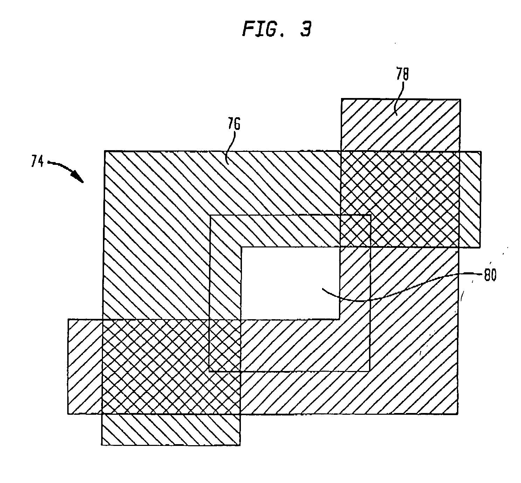

FIG. 3 is a top plan schematic view of a blading device used in connection with the present invention.

FIG. 4 is a top plan schematic view illustrating a semiconductor substrate after a first portion of a feature is formed thereon in accordance with the present invention.

FIG. 5 is a top plan schematic view illustrating a semiconductor wafer after a second portion of the feature is formed thereon.

### DETAILED DESCRIPTION OF THE PREFERRED EMBODIMENTS

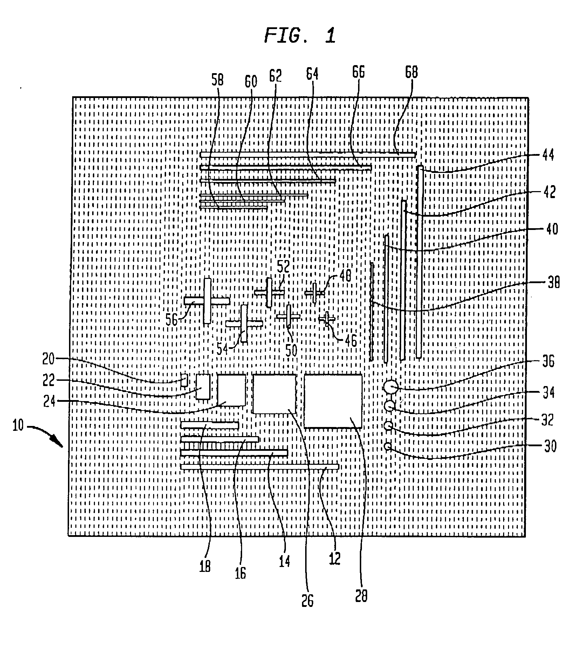

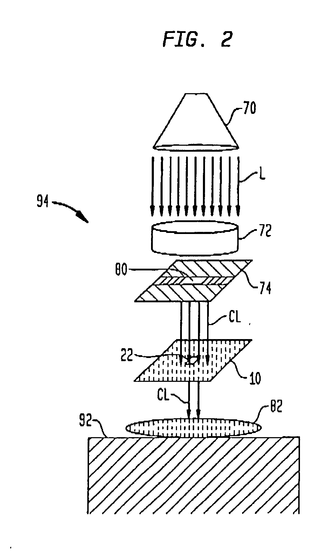

A reticle 10 of the present invention is shown in FIGS. 1 and 2. A significant aspect of the present invention is that the reticle 10 includes a plurality of open design areas (i.e., open shapes) 12-68 that can be used in various combinations to facilitate the formation of a feature on a semiconductor substrate. The feature may actually be formed on a semiconductor device, such as an integrated circuit chip, or on the kerf between prospective devices as they exist on a wafer during the fabrication process.

It should be appreciated that the shape of the open design areas 12-68 shown in FIG. 1 have been selected by way of example only. Thus, infinite configuration and size combinations can be selected for the open design areas arranged on reticle 10 while remaining within the scope the present invention. Further, the quantity of open design areas on the reticle 10 can be substantially less or more than the quantity shown in FIG. 1. In this regard, the minimum quantity of open design areas of reticle is two, while there is no maximum limit on the quantity of open design areas within the scope of the present invention.

By way of example, FIG. 1 illustrates that open design areas 12-68 can be classified generally into six groups based on their overall configuration. One group includes elongated horizontal quadrilaterals 12-18; a second group includes quadrilaterals 20-28; a third group includes circles 30-36; a fourth group includes elongated vertical quadrilaterals 38-44; a fifth group includes combinations of orthogonal quadrilaterals 46-56; and a sixth group includes elongated horizontal quadrilaterals 58-68.

As discussed above and further below, one aspect of the present invention relates to sequentially passing light waves through two or more of the open design areas 12-68 of reticle 10 and thus, sequentially exposing selected areas on a semiconductor substrate to such light waves so that a feature is subsequently formed on the substrate based on the combined shape of two or more of the open design areas.

A photolithographic system 94 in accordance with the present invention is shown schematically in FIG. 2. It should be appreciated that the photolithographic system shown in FIG. 2 and described herein is by way of example only. Thus, components may be modified added or deleted from the photolithographic system 94 while remaining within the scope of the present invention. As shown in FIG. 2, photolithographic system 94 includes a light source 70. The light source 70 may comprise a UV light source, which is well known in the semiconductor fabrication industry. Other acceptable light sources may produce near UV light waves, x-rays or other light waves suitable for creating features on a semiconductor substrate. Thus, while light source 70 will be described herein by way of example as producing UV light waves L, as illustrated in FIG. 2, it should be understood that the present invention is not limited to a UV light source.

UV light waves L are shown in FIG. 2 as falling incident upon a condenser lens 72. As the light waves pass through condenser lens 72, they fall upon blading device 74 including adjustable blinds 76 and 78 that effectively shield the light waves from passing therethrough. The UV light waves then pass through opening 80 of the blading device 74 and fall incident upon reticle 10. Much of the light waves will be shielded by opaque blinds 76 and 78 of the blading device 74. Thus, only a relatively small percentage of the UV light waves generated by light source 70 may actually pass through opening 80 of blading device 74 and contact reticle 10. This aspect of the present invention will be further discussed below in accordance with one preferred method of fabricating a semiconductor device.

A semiconductor substrate 82 is shown in FIG. 2 in conjunction with a stepper device 92. As discussed above, the semiconductor substrate comprises at least a semiconductor wafer, such as a silicon wafer. The semiconductor substrate may also comprise other composition layers such as a layer of oxide, polysilicon, photoresist and various other materials that are acceptable for use during photolithography processes.

The stepper device 92 may comprise various known steppers that can achieve extremely accurate alignment and stepping functions to assure high reliability in connection with the present photolithographic process.

A unique aspect of the stepper 92 of the present invention is that it may be programmed to create selective relative movement between reticle 10 and the semiconductor substrate 82 so that the light waves L contact the semiconductor substrate B2 after sequentially passing through a combination of two or more of the open design areas 12-68 of reticle 10.

Although FIG. 2 schematically illustrates stepper 92 in association with semiconductor substrate 82, it should be understood that stepper 92 may retain all other components of the photolithographic system 94 and may cause relative movement of various components such as the blading device 80, the reticle 10 and the semiconductor substrate 82 while performing the present method of fabricating a semiconductor device. It is within the skill of one of ordinary skill in the art to program stepper 92 so as to achieve the desired relative movement between certain of the components of system 94.

In accordance with a preferred method of fabricating a semiconductor device, the semiconductor substrate 82, the reticle 10 and the blading device 74 may be appropriately secured within stepper device 92. Light source 70 and condenser lens 72 may be inherent components within stepper device 92. Other components of the photolithographic system 94 arranged within stepper device 92 that are not shown in FIG. 2 include a mirror for reflecting light waves emanating from the UV light source, a filter for filtering the light waves onto condenser lens 72, and an additional lens system, such as a reduction lens system, which may be arranged between reticle 10 and the semiconductor substrate 82.

Reticle 10 is thus arranged within stepper device 92 and light source 70 is activated so that UV light waves L are generated and passed through condenser lens 72. The condensed light waves are then shielded by adjustable blinds 76 and 78 of blading device 74 while certain of the UV light waves are permitted to pass through opening 80 and fall upon a desired area of reticle 10.

By way of example, FIG. 2 illustrates that in accordance with a first step of the preferred method, the UV light waves only pass through open design area 22 of reticle 10. This precise arrangement is obtained by a combination of adjusting the size of opening 80 and relative movement and alignment achieved by stepper device 92 between blading device 74 and reticle 10.

The UV light waves that pass through open design area 22 of reticle 10 then fall upon semiconductor substrate 82. In one example, a positive photoresist sequence may be performed where portions of a photoresist layer on semiconductor substrate 82 that are exposed to UV light waves become highly soluble in selected solvents. Although the preferred embodiment described herein relates to a positive photoresist sequence, it should be understood that a such positive photoresist sequence is simply a matter of design choice. Thus, features can also be formed in accordance with the present invention by using a negative photoresist sequence as discussed above.

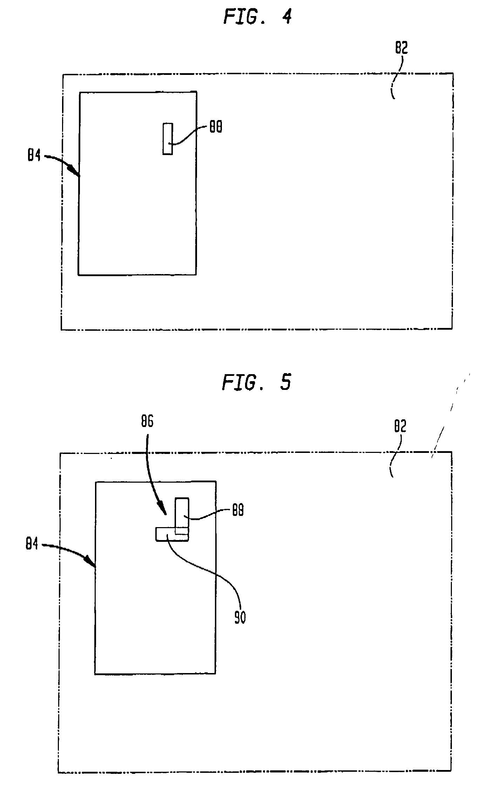

FIG. 4, illustrates an exposed area 88 on a prospective integrated circuit chip 84 of semiconductor substrate 82 that will subsequently be formed into part of a composite feature. After the photoresist layer has been exposed to UV light waves that pass through open design area 22 as indicated by area 88, stepper device 92 is activated to create further relative movement between reticle 10, semiconductor substrate 82 and blading device 74 so that a sequential exposure step may be performed. In the next exposure step, light waves that pass through opening 80 of blading device 74 may be directed to only pass through open design area 18 of reticle 10 so that the light waves fall incident upon semiconductor substrate 82 at an area 90 precisely calculated to correspond with area 88 so that a final feature can subsequently be formed having the shape of a backwards L as indicated by composite area 86. This step of the present invention is shown in FIG. 5.

After exposure steps are completed, and all potential features are formed on semiconductor chip 84, traditional steps of completing feature formation are carried out on the semiconductor substrate 82, such as developing/hard baking the feature, performing an oxide etch (in the case where an oxide layer is formed beneath the photoresist), and finally, stripping the remaining photoresist off of the semiconductor substrate 82.

The method of the present invention described above may be particularly advantageous when it is desirable to form a custom feature comprising a combination of shapes. It is desirable for final feature 86 to be formed from contiguous areas on a semiconductor substrate, which are created by using a combination of open design areas on reticle 10. While the example of the method discussed above involved two sequential exposure steps coupled with relative movement of the reticle 10 and semiconductor substrate 82 (and possibly blading device 74) it should be understood that the final feature may be a combination of more than two sequential exposure and relative movement steps. Although the invention herein has been described with reference to particular preferred embodiments and preferred method steps, it should be understood that such embodiments and methods are merely illustrative of the preferred structure and features of the present invention and steps of the preferred method. Thus, it should be understood that numerous modifications can be made to the structure and arrangement of components and steps of the preferred methods without departing from the spirit and scope of the present invention, which is defined by the following claims.

## Claims

1. A method of fabricating a semiconductor device, comprising:
(a) arranging a reticle in a desired location, said reticle having a plurality of open design areas;
(b) activating a light source to generate light waves that pass through a first open design area of said reticle, and exposing a corresponding first selected area of a semiconductor substrate to said light waves; and
(c) then passing said light waves through a second open design area of said reticle and exposing a corresponding second selected area of the semiconductor substrate to said light waves, whereby a feature is subsequently formed on said semiconductor substrate based on a combination of at least said first and second selected areas.

2. The method of claim 1 wherein said feature is directly formed by positive exposure of said first and second selected areas of said semiconductor substrate to said light waves.

3. The method of claim 1 wherein said feature is indirectly formed by negative exposure of said first and second selected areas of said semiconductor substrate to said light waves.

4. The method of claim 1 further comprising the step of passing said light waves through a condenser lens prior to passing said light waves through said first and second open design areas of said reticle.

5. The method of claim 1 further comprising using a blading device having an opening and a light shielding area to shield some of said light waves so that only the unshielded light waves pass through said opening and said first or second open design areas of said reticle.

6. The method of claim 5 further comprising the step of adjusting said opening of said blading device to a desired size so as to selectively shield said light waves from passing therethrough.

7. The method of claim 1 further comprising utilizing a stepper device to create relative movement between said reticle and said semiconductor substrate so that said second selected area is precisely arranged with respect to said first selected area before being exposed to said light waves.

8. The method of claim 2 further comprising the step of passing said light waves through a condenser lens prior to passing said light waves through said first and second open design areas of said reticle.

9. The method of claim 8 further comprising using a blading device having an opening and a light shielding area to shield some of said light waves so that only the unshielded light waves pass through said opening and said first or second open design areas of said reticle.

10. The method of claim 9 further comprising the step of adjusting said opening of said blading device to a desired size so as to selectively shield said light waves from passing therethrough.

11. The method of claim 10 further comprising utilizing a stepper device to create relative movement between said reticle and said semiconductor substrate so that said second selected area is precisely arranged with respect to said first selected area before being exposed to said light waves.

12. The method of claim 3 further comprising the step of passing said light waves through a condenser lens prior to passing said light waves through said first and second open design areas of said reticle.

13. The method of claim 12 further comprising using a blading device having an opening and a light shielding area to shield some of said light waves so that only the unshielded light waves pass through said opening and said first or second open design areas of said reticle.

14. The method of claim 13 further comprising the step of adjusting said opening of said blading device to a desired size so as to selectively shield said light waves from passing therethrough.

15. The method of claim 14 further comprising utilizing a stepper device to create relative movement between said reticle and said semiconductor substrate so that said second selected area is precisely arranged with respect to said first selected area before being exposed to said light waves.

16. A system for fabricating a semiconductor device, comprising:
(a) a light source;
(b) a reticle having a plurality of open design areas including first and second open design areas, said light source adapted to generate light waves that pass through said first open design area of said reticle and contact a corresponding first selected area of a semiconductor substrate, said light waves subsequently pass through said second open design area of said reticle and contact a corresponding second selected area of the semiconductor substrate; and
(c) a stepper device programmed to create selective relative movement between said reticle and the semiconductor substrate so that the light waves first contact the first selected area of the semiconductor substrate for a predetermined time, and then contact the second selected area for a predetermined time whereby a feature is subsequently formed on the semiconductor substrate based on a combination of at least said first and second selected areas.

17. The system of claim 16 further comprising a condenser lens, said light waves passing through said condenser lens prior to passing through said first and second open design areas of said reticle.

18. The system of claim 17 further comprising a blading device having an opening and a light shielding area to shield some of said light waves so that only the unshielded light waves pass through said opening of said first and second open design areas of said reticle.

19. The system of claim 18 wherein said blading device is adjustable so that said opening can be adjusted to a desired size.

20. The system of claim 19 wherein said adjustable blading device is at least partially controlled by said stepper device.
